# EUROPÄISCHE PATENTSCHRIFT

(11) **EP 3 146 807 B1**
(45) Veröffentlichungstag und Bekanntmachung des Hinweises auf die Patenterteilung: **12.12.2018**
(21) Anmeldenummer: 15729333.3
(22) Anmeldetag: 21.05.2015
(51) Int. Cl.: H05K 1/02, H05K 3/00

(54) **VERFAHREN ZUR HERSTELLUNG EINER LEITERPLATTE UND LEITERPLATTE**
METHOD FOR PRODUCING A CIRCUIT BOARD AND CIRCUIT BOARD
PROCÉDÉ DE FABRICATION D'UN CIRCUIT IMPRIMÉ ET CIRCUIT IMPRIMÉ

(30) Priorität: 23.05.2014 DE 102014008148
(43) Veröffentlichungstag der Anmeldung: 29.03.2017
(73) Patentinhaber: Schweizer Electronic AG, 78713 Schramberg (DE); Continental Automotive GmbH, 30165 Hannover (DE)
(72) Erfinder: Gottwald, Thomas, 78655 Dunningen (DE); Reisslöhner, Bernd, 86687 Kaisheim (DE); Rall, Thomas, 78655 Dunningen Lackendorf (DE); Brey, Roland, 93458 Eschlkam (DE); Hauer, Gerald, 93180 Deuerling (DE); Steckermeier, Tobias, 93186 Pettendorf (DE)
(74) Vertreter: Glawe, Delfs, Moll
(86) Internationale Anmeldenummer: PCT/EP2015/001035
(87) Internationale Veröffentlichungsnummer: WO 2015/176821

(56) Entgegenhaltungen:
- EP-A2- 0 766 506
- DE-U1-202011 110 068
- US-A1- 2011 096 495
- US-A1- 2012 024 575

## Beschreibung

### Technisches Gebiet

Die vorliegende Erfindung betrifft den Bereich der Leiterplattenherstellung und insbesondere die Herstellung von Inlays zum Einsetzen in Leiterplatten bzw. Leiterplatten, deren Herstellung ein Einsetzen von Inlays umfasst.

### Beschreibung des Standes der Technik

Inlays für Leiterplatten sind bekannt und finden breite Verwendung. Als ein Beispiel sei die aus der DE 10 2005 047 025 A1 bekannte mehrlagige Leiterplatte genannt, die ein Inlay aus einem massiven Kupferblock umfasst, das in eine dafür vorgesehene Ausnehmung in der Leiterplattenschichtabfolge eingesetzt ist.

Derartige Inlays werden üblicherweise einzeln gefertigt, insb. durch Ausstanzen aus einer Kupferplatte oder einer Platte aus anderem geeigneten Material, um dann anschließend einzeln in dazu vorgesehene Ausnehmungen in einer Leiterplatte (bzw. einer Leiterplatte in einem Zwischenfertigungsschritt) eingesetzt zu werden.

Aus der DE 20 2011 110 068 U1 ist ein Leiterplattenelement mit mindestens einem Einlegeteil bekannt, hergestellt aus einem Leiterplattenhalbzeug mit mindestens einer Trägerschicht und einer auf der Trägerschicht angeordneten zweiten Schicht mit mindestens einer Aussparung zur Aufnahme eines Einlegeteils, mit darin eingelegtem Einlegeteil und auf die zweite Schicht aufgelegter Prepreg-Abdeckung, wobei ein zwischen Einlegeteil und Aussparung vorhandener Spalt mit durch den Verpressdruck verflüssigtem Harz durch Verpressen der Schichtanordnung gefüllt ist und Form und Größe der Aussparung unter Berücksichtigung des einzulegenden Einlegeteils derart ausgebildet sind, dass das Volumen des Spalts im wesentlichen dem zur Verfügung stehenden Harzvolumen entspricht.

Weitere Leiterplatten bzw. Leiterplattenelemente mit Inlays sind aus EP 0 766 506 A2, US 2012/0023475 A1 und US 2011/0096495 A1 bekannt.

Demgegenüber schlägt die Erfindung ein Verfahren zum Herstellen von Leiterplatten mit den

Der Erfindungsgedanke besteht darin, in Abkehr von der aus dem Stand der Technik bekannten Vorgehensweise, nämlich für jedes einzelne Inlay eine passende Ausnehmung in der dazu vorgesehenen Leiterplattenschicht auszufräsen, nun eine größere Ausnehmung vorzusehen, in die eine Mehrzahl von Inlays einzusetzen ist. Hierzu verfügen die Inlays erfindungsgemäß über Positionierelemente, um sie an der richtigen Stelle in die Ausnehmung mit dem gewünschten Abstand zueinander einzusetzen. An dem die Ausnehmung in der Leiterplattenschicht definierenden Rahmen aus Leiterplattenmaterial sind entsprechende komplementäre Ausrichtungselemente vorgesehen. Unter dem Begriff des "Positionierelements" sind im Rahmen dieser Anmeldung sowohl zwischen einem Inlay und dem umgebenden Leiterplattenmaterial wirksame Vorsprünge oder Aussparungen als auch zwischen aneinandergrenzenden Inlays wirksamen Abstandselementen oder -haltern zu verstehen.

Das erfindungsgemäße Vorgehen gestattet das Verlegen von Inlays in einer Leiterplattenschicht mit sehr geringen Abständen, da die Positionierelemente im Stanzvorgang sehr präzise auch mit kleinen Abmessungen ausgebildet werden können. Als Folge der geringen Abstände bzw. Lücken zwischen den einzelnen Inlays wird beim nachfolgenden Laminiervorgang mit einer darüber gelegten Prepreg-Schicht vergleichsweise wenig verflüssigtes Harzmaterial zwischen den Inlays benötigt, wodurch ein Schichtaufbau mit wenigen und dünnen Prepregs möglich wird, was zu einer Konstruktion mit geringerem thermischen Widerstand zwischen den Inlays und einem an einer der Oberflächen angeschlossenen Kühlkörper führt. Erfindungsgemäß lassen sich so Spalte zwischen den Inlays in der Größenordnung von um die 100 µm realisieren (gegenüber Spaltbreiten aus dem Stand der Technik im Bereich 1 bis 2 mm) .

Nach dem Laminieren werden die Positionierelemente bzw. komplementären Ausrichtungselemente zwischen den Inlays getrennt. Dies geschieht zu Zwecken der Potentialtrennung und betrifft daher insb. die zwischen Inlays wirksamen Abstandselemente bzw. -halter; nicht leitende Kontaktierungen der Positionierelemente bzw. komplementären Ausrichtungselemente (also zwischen dem nicht-leitenden Leiterplattenmaterial und einem Inlay) müssen nicht unbedingt getrennt werden. Dies kann bspw. durch Bohren (Durchbohren, Tiefenbohren) und/oder Fräsen (Durchfräsen, Tiefenfräsen) o.dgl. erfolgen.

Die so entstandenen Löcher können bspw. mit einem nicht-leitenden Material gefüllt werden.

Erfindungsgemäß kann im Schnitt pro zu verlegendem Inlay mindestens ein Positionierelement vorgesehen sein. In weiterer Ausführungsform können mindestens zwei Positionierelemente je angrenzendem/benachbarten Inlay vorgesehen sein. Da eine statische Fixierung typischerweise über drei Punkte erfolgt, können je Inlaypaar drei Positionierelemente vorgesehen sein.

Der Rahmen der Ausnehmung in der Leiterplattenschicht kann insgesamt mindestens eine Zahl von zwei komplementären Ausrichtungselementen je an dem Rahmen angrenzenden Inlay minus zwei aufweisen (d.h. A ≥ 2I - 2, wobei A die Zahl der komplementären Ausrichtungselemente und I die Zahl der an dem Rahmen angrenzenden Inlays angibt). Zwischen zwei angrenzenden Inlays kann mindestens ein als Abstandselement ausgebildetes Positionierelement vorgesehen sein. Zwischen zwei angrenzenden Inlays sollten praktischerweise mindestens so viele Abstandselemente vorgesehen sein, dass die Inlays für den weiteren Verarbeitungsablauf statisch fixiert sind.

Weitere Vorteile und Ausgestaltungen der Erfindung ergeben sich aus der Beschreibung und der beiliegenden Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispieles in der Zeichnung schematisch dargestellt und wird im folgenden unter Bezugnahme auf die Zeichnung ausführlich beschrieben.

### Kurzbeschreibung der Zeichnung

Figur 1 zeigt eine Draufsicht auf eine Leiterplattenschicht während der Fertigung mit mehreren erfindungsgemäß eingesetzten Inlays.
Figur 2a zeigt einen ersten Ausschnitt aus der Darstellung der Figur 1 in Vergrößerung.
Figur 2b zeigt einen zweiten Ausschnitt aus der Darstellung der Figur 1 in Vergrößerung.
Figur 3 zeigt eine Draufsicht auf ein anderes Beispiel einer Leiterplattenschicht während der Fertigung mit zwei erfindungsgemäß eingesetzten Inlays.
Figur 4 zeigt eine Draufsicht auf ein weiteres Beispiel einer Leiterplattenschicht während der Fertigung mit zwei erfindungsgemäß eingesetzten Inlays.

### Ausführliche Beschreibung

In den Figuren bezeichnen gleiche Bezugszeichen gleiche oder ähnliche Elemente.

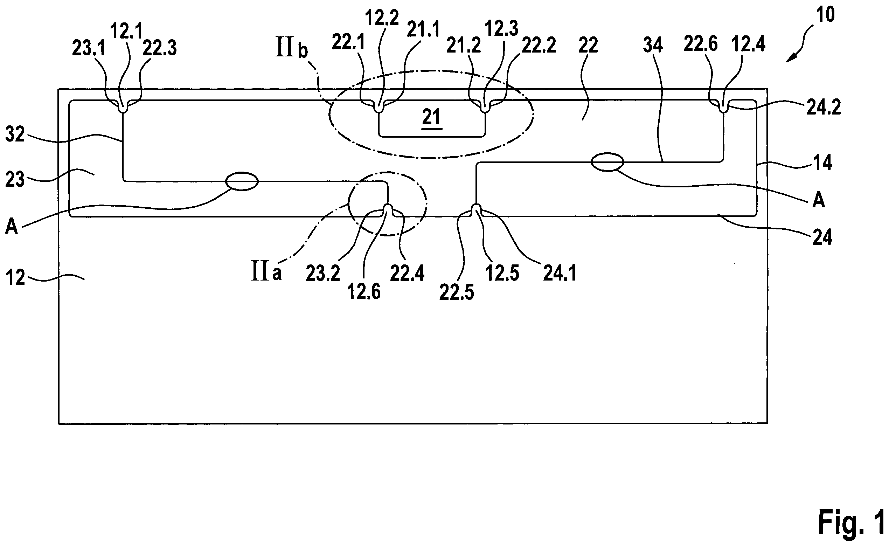

Figur 1 zeigt in Draufsicht eine Schichtabfolge zur Herstellung einer Leiterplatte 10 während des Herstellungsprozesses.

Die dem Betrachter der Figur 1 zugewandte oberste Schicht ist eine Leiterplattenschicht 12 aus einem nicht-leitenden Leiterplattenmaterial, wie bspw. FR4 o.dgl.

Der Begriff des "Positionierelements" wird im Umfang der vorliegenden Patentanmeldung und der folgenden Beschreibung als Bezeichnung für jegliche Art von an einem Inlay, insb. einer Inlaykante, ausgebildeten Element verwendet, das dazu geeignet ist, das Inlay beim Einsetzen in eine dazu vorgesehene Ausnehmung in einer Leiterplattenschicht zu positionieren. Bei derartigen Positionierelementen kann es sich insbesondere, aber nicht ausschließlich, um Nasen und/oder Ausbuchtungen und/oder Vorsprünge und/oder Aussparungen und/oder Einbuchtungen und/oder Rücksprünge o.dgl. handeln. Die Positionierelemente können an einer oder mehreren Inlaykanten bzw. Seitenkanten vorgesehen sein, wobei mit dem Begriff der Inlaykante auch die Ecke eines Inlays umfasst ist.

Die Leiterplattenschicht 12 weist eine Ausnehmung 14 auf, in die mehrere (in dem dargestellten Ausführungsbeispiel vier) Inlays 21, 22, 23, 24 eingesetzt sind. Das Leiterplattenmaterial um die Ausnehmung 14 dient als Rahmen für die puzzleartig darin eingesetzten Inlays 21, 22, 23, 24.

Jedes der Inlays 21 bis 24 umfasst mindestens zwei Positionierelemente. Insbesondere umfasst jedes der Inlays 21 bis 24 pro benachbart bzw. angrenzend angeordnetem Inlay zwei Positionierelemente. In dem dargestellten Ausführungsbeispiel sind dies Aussparungen, die mit an dem Rahmen komplementär ausgebildeten Nasen als Ausrichtungselemente eingreifen. Andere Ausgestaltungen der Positionierelemente sind selbstverständlich möglich.

So umfasst das erste Inlay 21, das lediglich an das zweite Inlay 22 angrenzt, ein erstes Positionierelement 21.1 und ein zweites Positionierelement 21.2. Ebenso umfassen das dritte Inlay 23 und das vierte Inlay 24, die gleichfalls jeweils nur an das zweite Inlay 22 angrenzen, jeweils ein erstes Positionierelement 23.1, 24.1 und ein zweites Positionierelement 23.2, 24.2. Das zweite Inlay 22 grenzt an die drei anderen Inlays 21, 23, 24 und umfasst entsprechend insgesamt sechs Positionierelemente 22.1 bis 22.6.

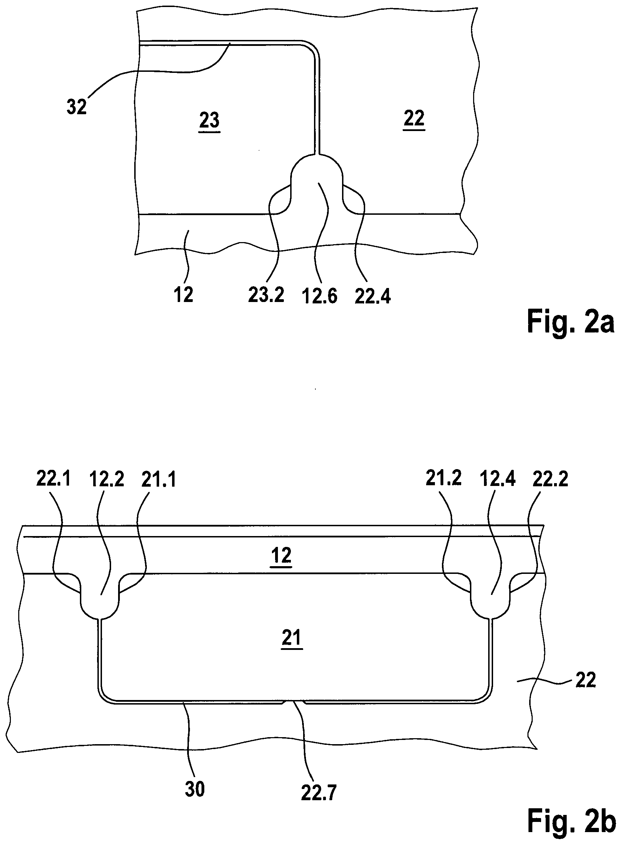

Wie insbesondere auch aus den Vergrößerungsdarstellungen der Figuren 2a und 2b ersichtlich ist, handelt es sich bei den Positionierelementen des dargestellten Ausführungsbeispiels um jeweils an einer Ecke des entsprechenden Inlays ausgebildete Aussparungen, die mit entsprechend ausgebildeten Ausrichtungselementen 12.1 bis 12.6 an dem Rahmen der Leiterplattenschicht 12 komplementär ausgebildet sind. Die Ausrichtungselemente 12.1 bis 12.6 sind in dem dargestellten Ausführungsbeispiel als nasenförmige Vorsprünge in der FR-4 Matrix ausgebildet.

Die Positionierelemente der Inlays sind in ihrer Dimensionierung dabei so ausgestaltet, dass sie beim Anlegen an das zugehörige komplementäre Ausrichtungselement zwischen den entsprechenden Inlays einen schmalen Spalt 30, 32, 34 erzeugen.

Zur Erzeugung eines auch während des nachfolgenden Laminiervorgangs stabil gehaltenen Spalts reichen jedoch zwei Positionierelemente zumindest nicht bei jeder Geometrie aus; so könnte sich bspw. in dem dargestellten Ausführungsbeispiel das erste Inlay 21, das in einer Ausnehmung des zweiten Inlays 22 platziert ist, in der Darstellung der Figur in Y-Richtung verschieben und dadurch ungewünscht in Kontakt mit dem zweiten Inlay 22 geraten.

Aus diesem Grunde ist an dem zweiten Inlay 22 ein schmaler Vorsprung vorgesehen, der als Abstandselement 22.7 dient. Durch die dadurch gebildeten drei Anlage- bzw. Ausrichtungspunkte für das erste Inlay 21, nämlich das erste Positionierelement 21.1 an dem zweiten Ausrichtungselement 12.2 und das zweite Positionierelement 21.2 an dem vierten Ausrichtungselement 12.4 sowie eine weitere Kante (der Kante parallel zu der Verbindungsgeraden zwischen den beiden Positionierelementen 21.1, 21.2) des ersten Inlays 21 an dem Abstandselement 22.7 des zweiten Inlays 22, ist das erste Inlay 21 in allen Freiheitsgraden der X-Y-Ebene eingeschränkt und somit für den Laminierprozess fixiert.

Die Geometrien des dritten und des vierten Inlays 23, 24 erfordern nicht unbedingt zwingend das Vorhandensein eines Abstandselements in den Spalten 32, 34 zwischen dem dritten bzw. vierten Inlay 23, 24 einerseits und dem zweiten Inlay 22 andererseits. Um jedoch auch hier sicherzustellen, dass während des Laminierprozesses durch womögliches Verschieben oder Verziehen keine ungewünschte Veränderung des Spaltmaßes zwischen den benachbarten Inlays entsteht, können an jeweils einem der beiden zueinander weisenden Inlays ebenfalls entsprechende Abstandselemente vorgesehen sein, bspw. an den in der Figur 1 mit "A" markierten Stellen. An langgestreckten Inlay-Geometrien können zur Sicherheit selbstverständlich mehrere Abstandselemente an definierten Stellen vorgesehen sein. Allerdings sollten nicht zu viele Abstandselemente vorgesehen sein, um den nachfolgenden Schritt des Entfernens der Abstandselemente nach dem Laminieren, bspw. durch Tiefenbohren und/oder durch Tiefenfräßen, nicht zu aufwändig zu gestalten.

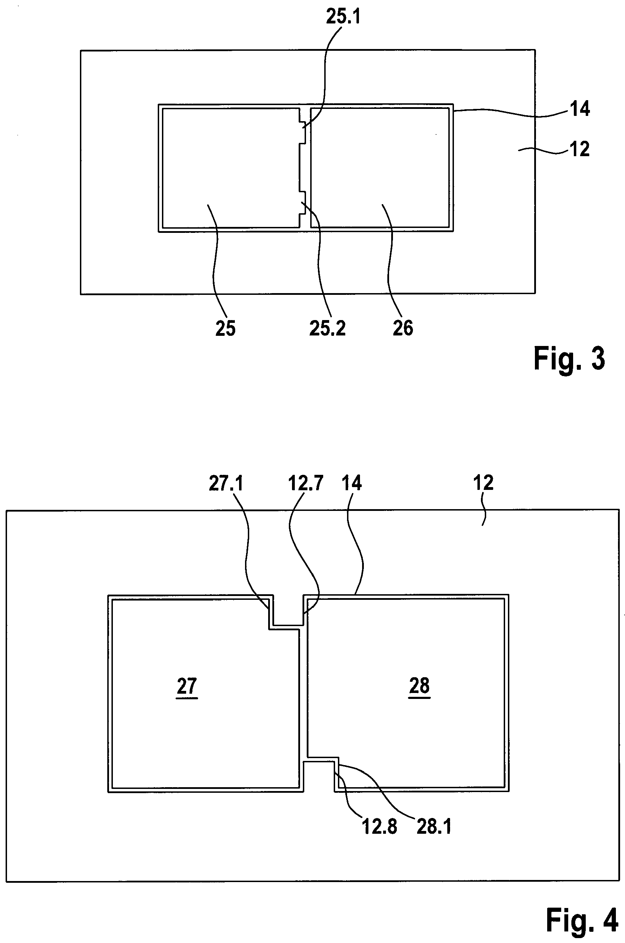

Zur weiteren Veranschaulichung des erfindungsgemäßen Gedankens ist in Figur 3 eine einfache Variante einer Leiterplattenschicht 12 mit zwei eingesetzten Inlays 25, 26 dargestellt. Ein erstes Inlay 25 weist zwei Positionierelemente 25.1, 25.2 auf, die als im wesentlichen rechteckige Vorsprünge ausgebildet sind und zu dem benachbarten zweiten Inlay 26 weisen, das kein Positionierelement aufweist. Aufgrund der sehr einfachen Geometrie (beide Inlays sind (bis auf die Ausnahme der beiden Vorsprünge 25.1, 25.2) im wesentlichen rechteckig, und auch die Ausnehmung 14 in der Leiterplattenschicht 12 weist im wesentlichen Rechteckform auf) sind keine weiteren Positionierelemente und/oder Ausrichtungselemente notwendig, um die Inlays innerhalb der Toleranzgrenzen in der Ausnehmung für die Folgeverarbeitung ausreichend zu fixieren. Die dargestellten Positionierelemente 25.1, 25.2 müssen nach einer weiteren Fixierung der Inlays entfernt werden, um einen Kurzschluss zwischen den Inlays zu vermeiden.

In Figur 3 ist eine weitere einfache Variante einer Leiterplattenschicht 12 mit zwei eingesetzten Inlays 27, 28 dargestellt. Die Ausnehmung 14 in der Leiterplattenschicht 12 weist zwei im wesentlichen rechteckige Vorsprünge 12.7 und 12.8 auf, die als Ausrichtungselemente dienen. Die beiden Inlays 27, 28 verfügen jeweils über ein Positionierelement 27.1 bzw. 28.1. Die beiden Positionierelemente 27.1, 28.1 sind in dem in Figur 4 dargestellten Ausführungsbeispiel als Aussparungen ausgebildet, die sich jeweils an einer Ecke des betreffenden Inlays 27 bzw. 28 befinden. Die Anordnung der Aussparungen 27.1 und 28.1 einerseits und der Vorsprünge 12.7 und 12.8 andererseits ist so gewählt, dass bei eingelegten Inlays 27, 28 jeweils eine Aussparung 27.1, 28.1 komplementär an einem zugeordneten Vorsprung 12.7 bzw. 12.8 zum Anliegen kommt und eine weitere ebene Kante jedes Inlays 27, 28 an einem Vorsprung 12.8 bzw. 12.7 anliegt. Oder mit anderen Worten: jedes der Ausrichtungselemente 12.7 und 12.8 hat zum einen die Funktion, komplementär mit der zugeordneten Aussparung 27.1 bzw. 28.1 einzugreifen, und zum anderen als Anlagefläche für eine Seitenkante des jeweils anderen Inlays 28 bzw. 27 zu dienen, so dass jedes Inlay in x-Richtung (der in der Darstellung der Figur 4 horizontalen Richtung) zwei Positionierungen an den Vorsprüngen hat und eine weitere an dem entsprechenden linken bzw. rechten Ausnehmungsrand. Hierzu ist jeder der beiden Vorsprünge 12.7, 12.8 etwas breiter ausgestaltet als die zugeordnete Aussparung 27.1 bzw. 28.1, um einen notwendigen bzw. gewünschten Abstand zwischen den beiden Inlays sicherzustellen und etwaige Toleranzen auszugleichen. Die Ausrichtungselemente 12.7, 12.8 übernehmen somit auch die Funktion des Abstandshalters. Da keine Positionierelemente bzw. Abstandshalter vorgesehen sind, die einen Kontakt zwischen den beiden Inlays herstellen (könnten), ist in diesem Ausführungsbeispiel auf ein Entfernen der Positionierelemente nicht notwendig.

Erfindungsgemäß wird somit ein Verfahren zum Herstellen von Leiterplatten durch Einlegen einer Mehrzahl von Inlays in eine entsprechend zur Aufnahme mehrere Inlays ausgebildeten Ausnehmung in einer Leiterplattenschicht bereitgestellt. Die Positionierung und Abstandshaltung erfolgt erfindungsgemäß so, dass die Abstandshalter entweder durch FR-4 Strukturen (Nasen, Vorsprünge) oder durch Inlaynasen oder durch eine Kombination beider Merkmale erzeugt werden, je nachdem was für die Anwendung im Hinblick auf die konkrete Inlaygeometrie vorteilhaft ist.

## Patentansprüche

1. Verfahren zur Herstellung einer Leiterplatte (10) mit einer Mehrzahl von Inlays (21, 22, 23, 24), mit den folgenden Schritten:
- Bereitstellen einer Mehrzahl von Inlays (21, 22, 23, 24), von denen mindestens ein Inlay mindestens ein Positionierelement (21.1, 21.2; 22.1 bis 22.7; 23.1, 23.2; 24.1, 24.2) aufweist,
- Aufbauen einer Schichtabfolge aus mehreren Leiterplattenlagen, mit mindestens einer Ausnehmung (14) zur Aufnahme von Inlays, wobei die Ausnehmung (14) vor dem Schritt des Einsetzens der Mehrzahl von Inlays (21, 22, 23, 24) in einer obersten Schicht (12) durch einen Rahmen aus nichtleitendem Leiterplattenmaterial definiert ist,
- Einsetzen der Mehrzahl von Inlays (21, 22, 23, 24) in die durch den Rahmen definierte Ausnehmung (14),
- Abdecken der Inlays (21, 22, 23, 24) mit einem nicht-leitenden Leiterplattenmaterial,
- Laminieren der Schichtabfolge, und
- Trennen zumindest der Positionierelemente (21.1, 21.2; 22.1 bis 22.7; 23.1, 23.2; 24.1, 24.2), die einen leitenden Kontakt zwischen benachbarten Inlays bereitstellen.

2. Verfahren nach Anspruch 1, bei dem die Positionierelemente (21.1, 21.2; 22.1 bis 22.7; 23.1, 23.2; 24.1, 24.2) Aussparungen und/oder Vorsprünge an den Inlay-Seitenkanten sind.

3. Verfahren nach Anspruch 1 oder 2, bei dem an dem Rahmen komplementäre Ausrichtungselemente (12.1 bis 12.6) ausgebildet sind, an denen die Positionierelemente (21.1, 21.2; 22.1 bis 22.7; 23.1, 23.2; 24.1, 24.2) der Inlays (21, 22, 23, 24) ausgerichtet werden.

4. Verfahren nach einem der Ansprüche 1 bis 3, bei dem die Positionierelemente (21.1, 21.2; 22.1 bis 22.7; 23.1, 23.2; 24.1, 24.2) durch Bohren und/oder Fräsen entfernt werden.

5. Verfahren nach einem der Ansprüche 1 bis 4, bei dem nur die zwischen zwei aneinandergrenzenden Inlays wirksamen Positionierelemente entfernt werden.

6. Verfahren nach einem der Ansprüche 1 bis 5, bei dem zum Entfernen der Positionierelemente (21.1, 21.2; 22.1 bis 22.7; 23.1, 23.2; 24.1, 24.2) erzeugte Löcher mit einem nicht-leitenden Material gefüllt werden.

7. Leiterplatte (10) mit einer Mehrzahl von Inlays (21, 22, 23, 24) erhältlich durch das Verfahren nach einem der Ansprüche 1 bis 6, wobei die Leiterplatte (10) zwischen benachbarten potentialgetrennten Inlays (21, 22, 23, 24) wenigstens ein Loch aufweist, das nach dem Laminieren der gebildeten Schichtabfolge durch Bohren und/oder Fräsen o.dgl. durch wenigstens eines der benachbarten Inlays erhältlich ist.

8. Leiterplatte (10) nach Anspruch 7, mit einer Mehrzahl von Inlays (21, 22, 23, 24), die unter Ausrichtung der Inlay-Positionierelemente (21.1, 21.2; 22.1 bis 22.6; 23.1, 23.2; 24.1, 24.2) an in der Ausnehmung (14) ausgebildeten komplementären Ausrichtungselementen (12.1 bis 12.6) eingesetzt sind.

9. Leiterplatte (10) nach Anspruch 7 oder 8, bei der im Schnitt je Inlay (21, 22, 23, 24) mindestens ein Positionierelement (21.1, 21.2; 22.1 bis 22.6; 23.1, 23.2; 24.1, 24.2) vorgesehen ist.

10. Leiterplatte (10) nach Anspruch 7 oder 8, bei der jedes Inlay (21, 22, 23, 24) je angrenzendem Inlay mindestens zwei Positionierelemente (21.1, 21.2; 22.1 bis 22.6; 23.1, 23.2; 24.1, 24.2) aufweist und je Inlay (21, 22, 23, 24) in der Ausnehmung (14) mindestens A = 2I - 2 komplementäre Ausrichtungselemente (12.1 bis 12.6) vorgesehen sind (wobei A die Zahl der komplementären Ausrichtungselemente und I die Zahl der Inlays angibt).

11. Leiterplatte (10) nach einem der Ansprüche 7 bis 10, bei der das durch Entfernen von Positionierelementen (21.1, 21.2; 22.1 bis 22.7; 23.1, 23.2; 24.1, 24.2) erzeugte wenigstens eine Loch mit einem nicht-leitenden Material gefüllt ist.

## Claims

1. Method of producing a printed circuit board (10) with a plurality of inlays (21, 22, 23, 24), having the following steps:
- supplying a plurality of inlays (21, 22, 23, 24), of which at least one inlay has at least one positioning element (21.1, 21.2; 22.1 to 22.7; 23.1, 23.2; 24.1, 24.2),
- building up a layer sequence from a plurality of printed-circuit-board layers, with at least one recess (14) for accommodating inlays, wherein, prior to the step of the plurality of inlays (21, 22, 23, 24) being inserted, the recess (14) is defined in an uppermost layer (12) by a frame made of non-conductive printed-circuit-board material,
- inserting the plurality of inlays (21, 22, 23, 24) into the recess (14) defined by the frame,
- covering the inlays (21, 22, 23, 24) with a non-conductive printed-circuit-board material,
- laminating the layer sequence, and
- cutting off at least the positioning elements (21.1, 21.2; 22.1 to 22.7; 23.1, 23.2; 24.1, 24.2) which establish a conductive contact between neighboring inlays.

2. Method according to Claim 1, in which the positioning elements (21.1, 21.2; 22.1 to 22.7; 23.1, 23.2; 24.1, 24.2) are cutouts and/or protrusions on the inlay side edges.

3. Method according to Claim 1 or 2, in which complementary aligning elements (12.1 to 12.6) are formed on the frame, the positioning elements (21.1, 21.2; 22.1 to 22.7; 23.1, 23.2; 24.1, 24.2) of the inlays (21, 22, 23, 24) being aligned thereon.

4. Method according to one of Claims 1 to 3, in which the positioning elements (21.1, 21.2; 22.1 to 22.7; 23.1, 23.2; 24.1, 24.2) are removed by drilling and/or milling.

5. Method according to one of Claims 1 to 4, in which it is only the positioning elements which act between two adjacent inlays which are removed.

6. Method according to one of Claims 1 to 5, in which holes produced for removal of the positioning elements (21.1, 21.2; 22.1 to 22.7; 23.1, 23.2; 24.1, 24.2) are filled with a non-conductive material.

7. Printed circuit board (10) with a plurality of inlays (21, 22, 23, 24) obtainable by the method according to one of Claims 1 to 6, wherein the printed circuit board (10) has at least one hole between adjacent electrically isolated inlays (21, 22, 23, 24), said hole being obtainable, following lamination of the layer sequence formed, by drilling and/or milling or the like through at least one of the adjacent inlays.

8. Printed circuit board (10) according to Claim 7 with a plurality of inlays (21, 22, 23, 24), which are inserted with the inlay-positioning elements (21.1, 21.2; 22.1 to 22.6; 23.1, 23.2; 24.1, 24.2) being aligned on complementary aligning elements (12.1 to 12.6) formed in the recess (14).

9. Printed circuit board (10) according to Claim 7 or 8, in which on average at least one positioning element (21.1, 21.2; 22.1 to 22.6; 23.1, 23.2; 24.1, 24.2) is provided per inlay (21, 22, 23, 24).

10. Printed circuit board (10) according to Claim 7 or 8, in which each inlay (21, 22, 23, 24) has at least two positioning elements (21.1, 21.2; 22.1 to 22.6; 23.1, 23.2; 24.1, 24.2) per adjacent inlay, and at least A = 2I - 2 complementary aligning elements (12.1 to 12.6) are provided in the recess (14) per inlay (21, 22, 23, 24) (where A is the number of complementary aligning elements and I is the number of inlays).

11. Printed circuit board (10) according to one of Claims 7 to 10, in which the at least one hole produced by removal of positioning elements (21.1, 21.2; 22.1 to 22.7; 23.1, 23.2; 24.1, 24.2) is filled with a non-conductive material.

## Revendications

1. Procédé de réalisation d'une carte à circuits imprimés (10), comportant une pluralité d'inserts ("inlays") (21, 22, 23, 24), comprenant les étapes suivantes consistant à :
- fournir une pluralité d'inserts (21, 22, 23, 24) dont au moins un insert présente au moins un élément de positionnement (21.1, 21.2 ; 22.1 à 22.7; 23.1, 23.2 ; 24.1, 24.2),
- construire une succession de couches de plusieurs nappes de carte à circuits imprimés, comportant au moins un évidement (14) pour recevoir des inserts, l'évidement (14) étant défini par un cadre en un matériau non conducteur de la carte à circuits imprimés, avant l'étape de la mise en place de la pluralité d'inserts (21, 22, 23, 24) dans une couche supérieure (12),
- mettre en place la pluralité d'inserts (21, 22, 23, 24) dans l'évidement (14) défini par le cadre,
- recouvrir les inserts (21, 22, 23, 24) d'un matériau non conducteur de la carte à circuits imprimés,
- laminer la succession de couches, et
- séparer au moins les éléments de positionnement (21.2, 21.2 ; 22.1 à 22.7 ; 23.1, 23.2 ; 24.1, 24.2) qui établissent un contact conducteur entre des inserts voisins.

2. Procédé selon la revendication 1, dans lequel les éléments de positionnement (21.2, 21.2 ; 22.1 à 22.7 ; 23.1, 23.2 ; 24.1, 24.2) sont des échancrures et/ou des saillies aux bords latéraux des inserts.

3. Procédé selon la revendication 1 ou 2, dans lequel des éléments d'orientation complémentaires (12.1 à 12.6) sont réalisés sur le cadre, sur lesquels les éléments de positionnement (21.2, 21.2 ; 22.1 à 22.7 ; 23.1, 23.2 ; 24.1, 24.2) des inserts (21, 22, 23, 24) sont orientés.

4. Procédé selon l'une des revendications 1 à 3, dans lequel les éléments de positionnement (21.2, 21.2 ; 22.1 à 22.7 ; 23.1, 23.2 ; 24.1, 24.2) sont enlevés par alésage et/ou fraisage.

5. Procédé selon l'une des revendications 1 à 4, dans lequel seuls les éléments de positionnement agissant entre deux inserts adjacents sont enlevés.

6. Procédé selon l'une des revendications 1 à 5, dans lequel des trous générés pour enlever les éléments de positionnement (21.2, 21.2 ; 22.1 à 22.7 ; 23.1, 23.2 ; 24.1, 24.2) sont remplis d'un matériau non conducteur.

7. Carte à circuits imprimés (10) comprenant une pluralité d'inserts (21, 22, 23, 24) et pouvant être obtenue par le procédé selon l'une des revendications 1 à 6, dans laquelle la carte à circuits imprimés (10) présente au moins un trou entre des inserts (21, 22, 23, 24) voisins à potentiel séparé, ledit trou pouvant être obtenu par alésage et/ou fraisage ou similaire à travers l'un au moins des inserts voisins, après le laminage de la succession de couches formée.

8. Carte à circuits imprimés (10) selon la revendication 7, comprenant une pluralité d'inserts (21, 22, 23, 24) qui sont mis en place sur des éléments d'orientation complémentaires (12.1 à 12.6) réalisés dans l'évidement (14), en orientant les éléments de positionnement d'insert (21.2, 21.2 ; 22.1 à 22.7 ; 23.1, 23.2 ; 24.1, 24.2).

9. Carte à circuits imprimés (10) selon la revendication 7 ou 8, dans laquelle, en moyenne, au moins un élément de positionnement (21.2, 21.2 ; 22.1 à 22.7 ; 23.1, 23.2 ; 24.1, 24.2) est prévu par insert.

10. Carte à circuits imprimés (10) selon la revendication 7 ou 8, dans laquelle chaque insert (21, 22, 23, 24) comprend au moins deux éléments de positionnement (21.2, 21.2 ; 22.1 à 22.7 ; 23.1, 23.2 ; 24.1, 24.2) par insert adjacent, et au moins A = 2I - 2 d'éléments d'orientation complémentaires (12.1 à 12.6) sont prévus par insert (21, 22, 23, 24) dans l'évidement (14) (A indiquant le nombre d'éléments d'orientation complémentaires et I indiquant le nombre d'inserts).

11. Carte à circuits imprimés (10) selon l'une des revendications 7 à 10, dans laquelle ledit au moins un trou généré par l'enlèvement d'éléments de positionnement (21.2, 21.2 ; 22.1 à 22.7 ; 23.1, 23.2 ; 24.1, 24.2) est rempli d'un matériau non conducteur.
